# EUROPEAN PATENT APPLICATION

(11) **EP 2 670 011 A1**
(43) Date of publication of application: **04.12.2013**
(21) Application number: 11822880.8
(22) Date of filing: 14.10.2011
(51) Int. Cl.: H02H 7/18, H01M 10/48, H02J 7/00

(54) **ELECTRICITY STORAGE SYSTEM**

(30) Priority: 15.10.2010 JP 2010232525
(71) Applicant: Sanyo Electric Co., Ltd., Osaka 570-8677 (JP)
(72) Inventor: NAKASHIMA, Takeshi, Moriguchi-shi Osaka 570-8677 (JP); IKE, Takehito, Moriguchi-shi Osaka 570-8677 (JP)
(74) Representative: Glawe, Delfs, Moll
(86) International application number: PCT/JP2011/073719
(87) International publication number: WO 2012/050207

(57) **Abstract**

There is provided an electricity storage system (10) which comprises an electricity storage device (30), a charge and discharge switch device (60) placed to be connected to the electricity storage device (30), a control block (80) which is a charge and discharge control device which controls charging from a power supply and discharging from the electricity storage device (30) to an external load, an electricity storage device breaker (50) provided between the electricity storage device (30) and the charge and discharge switch device (60), storage battery state detection units (38), (40), (42) which detect the storage battery state information at a connection point between the electricity storage device (30) and the electricity storage device breaker (50), and the detection units (62), (64), (66) which detect the state information at a connection point between the electricity storage device breaker (50) and the charge and discharge switch device (60).

## Description

### TECHNICAL FIELD

The present invention relates an electricity storage system to which a storage battery is connected through a breaker.

### BACKGROUND ART

Effective usage of the energy is realized with the use of an electricity storage device such as a secondary battery. For example, in recent years, solar light power generation systems have been actively developed as eco-friendly, clean energy. Because a photoelectric conversion module which converts the solar light into electric power does not have an electricity storage function, the photoelectric conversion module is in some cases used in combination with a secondary battery. For example, the energy is effectively used by charge and discharge control to charge the electric power generated by the photoelectric conversion module into the secondary battery once and to discharge the electricity from the secondary battery in response to a request from an external load or the like.

When an electricity storage system which executes the charge and discharge control in a combination of a secondary battery and a power supply is formed in this manner, it is necessary to monitor a state of charge of the electricity storage device which comprises a secondary battery.

For example, Patent Literature 1 discloses a control system of an independent-type power supply using a solar light battery, comprising a solar light battery, an efficiency control unit including a voltage boosting circuit, a charge and discharge control unit, and a storage battery to be connected to a load, wherein connection point breakers are provided between the solar light battery and the efficiency control unit and between the storage battery and the load, respectively. The former connection point breaker is disconnected when the generated electric power of the solar light power generation is excessive, and the latter connection point breaker is disconnected when the storage battery is in danger of being excessively discharged. The reference discloses that an electric power meter/voltage meter for output of the storage battery is provided in the charge and discharge control unit, a voltage and a current at a charge electric power sent from a current control circuit are measured, and the input from the current control circuit is disconnected so that an output voltage and an output current of the storage battery can be measured.

### [Related Art References]

### [Patent Literature]

[Patent Literature 1] JP 2008-251612 A

### DISCLOSURE OF INVENTION

### [Technical Problem]

Because a state of charge of a storage battery can be estimated based on an inter-terminal voltage and an input/output current of the storage battery, a current and voltage detection unit is provided in the storage battery. Even when the electricity storage device comprises a plurality of storage batteries, the current and voltage detection unit may be provided in individual storage batteries, so that the state of charge/discharge of each storage battery can be estimated. In general, in order to protect the storage battery, when an abnormality occurs, a semiconductor switch is switched OFF so that the storage battery is isolated from a charge/discharge path. However, with only the current and voltage detection unit provided in each individual storage battery, it is not possible to detect abnormality occurring in the charge/discharge path, and, thus, the storage battery cannot be appropriately isolated.

An advantage of the present invention is addressed to provide an electricity storage system which enables protection of the storage battery by preventing excessive charge or excessive discharge of the electricity storage device.

### [Solution to Problem]

According to one aspect of the present invention, there is provided an electricity storage system comprising an electricity storage device which has a storage battery, charges electric power supplied from an electric power supply, and discharges the charged electric power to an external load; a charge and discharge control unit which controls charging and discharging; a suitable charge and discharge monitoring unit which monitors a state of charge and discharge; a breaker which is connected to the electricity storage device; a first detection unit which detects storage battery state information from a side nearer to the storage battery than the breaker; and a second detection unit which detects state information from a side nearer to the electric power supply than the breaker.

### [Advantageous Effects of Invention]

According to various aspects of the present invention, excessive charging and excessive discharging of the electricity storage device can be prevented.

### BRIEF DESCRIPTION OF DRAWINGS

FIG. 1 is a diagram for explaining a structure of an electricity storage system according to a preferred embodiment of the present invention.
FIG. 2 is a diagram for explaining storage battery selection control using a second voltage in an electricity storage system according to a preferred embodiment of the present invention, picking and showing necessary constituent elements.

### BEST MODE FOR CARRYING OUT THE INVENTION

A preferred embodiment of the present invention will now be described in detail with reference to the drawings. In the following description, a lithium ion battery is explained as the storage battery, but alternatively, other secondary batteries may be employed. For example, the storage battery may be a nickel-metal hydride battery, a nickel-cadmium battery, or the like.

In addition, in the following description, a solar light generated electric power and external commercial electric power are explained as an electric power supply, but alternatively, other electric power supplies such as, for example, wind generated electric power may be employed. Moreover, when the wind generated electric power or the like is used, a conversion device for converting the wind generated electric power into direct current electric power may be provided in the electricity storage system as necessary. Furthermore, the number of the storage batteries in the electricity storage device and the number, a voltage value, or the like of solar light power generation modules (panels) forming a photoelectric conversion array for solar light power generation described below are merely exemplary for the purpose of explanation, and may be suitably changed according to the specification of the electricity storage system or the like.

In addition, in the following description, similar elements are assigned the same reference numerals in all drawings, and explanations will not be repeated. Moreover, in the explanation of the present specification, reference numerals which have been already used are referred to as necessary.

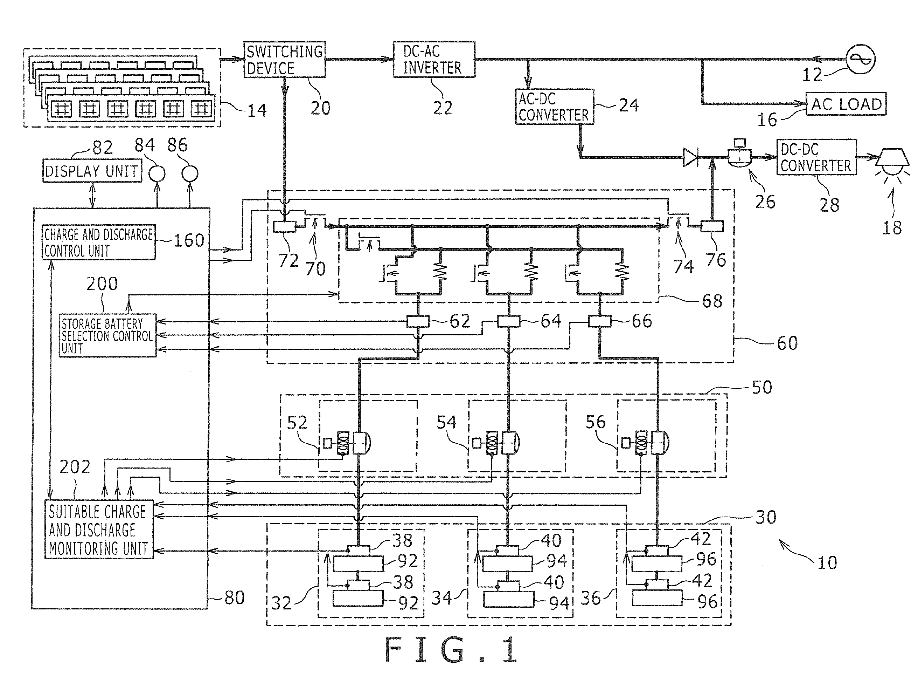

FIG. 1 is a diagram for explaining a structure of an electricity storage system 10. The electricity storage system 10 comprises an electricity storage device 30, a load-side breaker 26, anelectricity storage device breaker 50, a charge and discharge switch device 60, and a control block 80. FIG. 1 also shows, although these are not constituent elements of the electricity storage system 10, an external commercial power supply 12 serving as a power supply, a photoelectric conversion array 14, an AC load 16 and a DC load 18 serving as external loads, and a DC-DC converter 28 which converts into a direct current voltage suitable for the DC load 18. In the following, alternating current will be referred to as AC and direct current will be referred to as DC, according to the circumstances. In FIG. 1, a wide solid line shows a flow of electric power and a narrow solid line with an arrow at an end shows a flow of a signal.

The AC load 16 is a device or the like which is driven by alternating current power, and is, for example, a rotary electric device, an air-conditioning device, or a mechanical device such as a machining device or an assembling device. The DC load 18 is a device or the like which is driven by direct current power, and is, for example, office equipment, a lighting device, or the like. The DC-DC converter 28 is a voltage converter which converts, for example, a direct current power of 96 V supplied from the electricity storage device 30 into a direct current power of about 12 V suitable for the office equipment or the like.

The external commercial power supply 12 serving as the electric power supply is an alternating current power supply of a single phase or three phases. A photoelectric conversion array 14 serving as the electric power supply is a direct current power supply in which a plurality of solar light power generation modules (panels) are combined, and, in the example configuration of FIG. 1, 4 solar light power generation blocks in which a plurality of solar light power generation modules (panels) are placed are used. The 4 solar light power generation blocks are connected in parallel to each other. When 6 solar light power generation modules placed in each solar light power generation block are connected in series, an output operation voltage of about 240 V can be realized, and, when 3 solar light power generation modules placed in each solar light power generation block are connected in series and the series connections are connected in parallel to each other, an output operation voltage of about 120 V can be realized.

A switching device 20 is a connection switching device having a function to change a connection state of the plurality of solar light power generation modules (panels) of the photoelectric conversion array 14, to switch the output operation voltage between a voltage of about 240 V and a voltage of about 120 V, as described above. As the output operation voltage is switched with this switching, the switching device 20 may also be called a voltage switching device from this viewpoint. In addition, in the wide meaning, the switching device changes the form of the power supply and converts the solar light power generation into a 240-V direct current power supply or a 120-V direct current power supply, and, thus, the switching device may be considered as a type of power supply conversion device.

In addition, the switching device 20 has a function to connect the generated electric power of the photoelectric conversion array 14 to the side of a DC-AC inverter 22 or to the charge and discharge switch device 60 in a manner to allow alternate switching.

When the photoelectric conversion array 14 is connected to the side of the DC-AC inverter 22, 6 solar light power generation modules are connected in series (series connection form), and the electric power generated by the solar light power generation module can be supplied to the DC-AC inverter 22 at a relatively high voltage. In the series connection form, the photoelectric conversion array 14 and the charge and discharge switch device 60 are electrically disconnected. When the photoelectric conversion array 14 is connected to the charge and discharge switch device 60, 3 solar light power generation modules are connected in series, and the series connections are connected in parallel (parallel connection form), and the electric power generated by the solar light power generation module can be supplied to the charge and discharge switch device 60 at a relatively low voltage. In the parallel connection form, the photoelectric conversion array 14 and the DC-AC inverter 22 are electrically disconnected.

The switching device 20 and the control block 80 are connected by a communication line (not shown). The switching between the series connection form and the parallel connection form is executed by an instruction from the control block 80, and the information indicating the series or parallel connection form is transmitted to the control block 80. When electric power is supplied to the DC-AC inverter 22, the series connection state in which the output operation voltage is about 240 V is employed.

The DC-AC inverter 22 is an electric power converter which converts direct current power to alternating current power, and may be considered in the wider meaning as a type of a power supply conversion device. The DC-AC inverter 22 has a function to convert the direct current power of about 240 V from the switching device 20 into an alternating current power and supply the same to the AC load 16. In some cases, the DC-AC inverter 22 may return the power to the side of the external commercial power supply 12, which is commonly called a reverse power flow or electricity selling.

An AC-DC converter 24 is an electric power converter which converts alternating current power to direct current power, and may be considered in a wider meaning as a type of a power supply conversion device. The AC-DC converter 24 converts alternating current power from the external commercial power supply 12 or the alternating current power converted by the DC-AC inverter 22 into direct current power as backup electric power when no direct current power is supplied from the electricity storage device 30 to the DC load 18. For example, when discharging of the electricity storage device 30 is limited for some reason, direct current power is supplied to the DC load 18 through the AC-DC converter 24.

The AC-DC converter 24 and the control block 80 are connected by a communication line (not shown) which can communicate digital data. Setting of an operation condition, an instruction value setting of the direct current power to be output, or the like are transmitted from the control block 80 to the AC-DC converter 24, and operation state data or the like is transmitted from the AC-DC converter 24 to the control block 80.

The load-side breaker 26 is an electric power disconnecting device provided between the electricity storage system 10 and the DC load 18. The load-side breaker 26 has a function to disconnect the flow of the electric power when a current greater than or equal to a predefined threshold flows when the direct current power is supplied from the electricity storage device 30 or the like through the DC-DC converter 28 to the DC load 18.

The load-side breaker 26 may be a manual type device, and, in order to set to an electricity flowing state which is a connected state, a user manually executes a switching operation. Theload-side breaker 26 and the control block 80 are connected by a communication line (not shown) which transmits a status signal, so that the control block 80 knows whether the load-side breaker 26 is currently in a connected state or in a disconnected state.

The charge and discharge switch device 60 is a charge and discharge switching device placed to be connected to the electricity storage device 30 to realize charging from the power supply and discharging from the electricity storage device 30 to an external load. More specifically, the charge and discharge switch device 60 is placed between the switching device 20 and the electricity storage device 30 as a side of a charge path and between the load-side breaker 26 and the electricity storage device 30 as a side of a discharge path.

The charge and discharge switch device 60 comprises a charge switch 70 on the side of the charge path, a discharge switch 74 on the side of the discharge path, and a storage battery selecting circuit 68 which can select a storage battery to be charged or discharged according to states of charge of a plurality of storage batteries 32, 34, and 36. In addition, in order to detect a state of charge/discharge, detection units (second detection units) 62, 64, and 66 are provided on the side of the electricity storage device 30, a charge-side current and voltage detection unit 72 is provided on the side of the charge switch 70 near the switching device 20, and a discharge-side current and voltage detection unit 7 6 is provided on the side of the discharge switch 74 near the load-side breaker 26.

The charge switch 70 and the discharge switch 74 are semiconductor switching elements which are switched ON and OFF by an electric signal; more specifically, a field-effect transistor (FET) may be employed. Each of the detection units 62, 64, and 66, the charge-side current and voltage detection unit 72, and the discharge-side current and voltage detection unit 76 may be formed by a voltage detecting sensor and a current detecting sensor. Because the electricity storage device 30 comprises 3 storage batteries 32, 34, and 36 as shown in FIG. 1, the detection units 62, 64, and 66 are provided corresponding to the storage batteries 32, 34, and 36, respectively. The numberofstorage batteriesofthe electricity storage device 30 is not limited to 3, and may be increased or decreased according to the necessary electric power. However, it is important that the charge and discharge switch device 60 is provided in the charge and discharge paths, so that the storage batteries appear to function as one battery in the electricity storage system 10.

The charge switch 70 and the discharge switch 74 are connected with the control block 80 by communication lines through which charge and discharge instructions are transmitted. The charge and discharge instructions from the control block 80 are realized by a 0/1 signal indicating the switching ON and OFF of each of the switches. The detection units 62, 64, and 66, the charge-side current and voltage detection unit 72, and the discharge-side current and voltage detection unit 76 are respectively connected to the control block 80 by a communication line through which detected information can be transmitted.

Similar to the load-side breaker 25, the electricity storage device breaker 50 has a function to disconnect the flow of electric power when a current greater than or equal to a predefined threshold flows. The electricity storage device breaker 50 is provided between the electricity storage device 30 and the charge and discharge switch device 60, and comprises 3 breakers 52, 54, and 56 corresponding to the 3 storage batteries 32, 34, and 36 of the electricity storage device 30, respectively. In FIG. 1, the breaker 52 is placed corresponding to the storage battery 32, the breaker 54 is placed corresponding to the storage battery 34, and the breaker 56 is placed corresponding to the storage battery 36. The 3 breakers 52, 54, and 56 are storage battery breakers having the same shape and the same performance, but in order to distinguish between the individual storage battery breaker and the electricity storage device breaker 50, which is a collected body of the 3 storage battery breakers, here, the individual storage battery breakers are simply referred to as breakers 52, 54, and 56.

The electricity storage device breaker 50 has a function to transmit and receive digital data to and from the control block 80, can switch from the connected state to the disconnected state by an instruction of the control block 80, and transmits to the control block 80 a status signal indicating whether the current state is the connected state or the disconnected state. The instruction signal and the status signal are transmitted with 0/1 signals. In FIG. 1, a signal line for transmitting the status signal is not shown. The transmission of these signals is executed for each of the breakers 52, 54, and 56. Similar to the load-side breaker 26, the electricity storage device breaker 50 can be switched from the disconnected state to the connected state in which electricity flows, by a manual switching operation by the user.

The electricity storage device 30 is formed by connecting the storage batteries 32, 34, and 36 in parallel. The storage batteries 32, 34, and 36 are combined batteries in which a plurality of lithium ion single batteries are combined, are secondary batteries which can be charged and discharged, and each has a structure in which 2 storage battery packs 92, 94, and 96 are connected in series. In the storage battery packs 92, 94, and 96, a plurality of lithium ion single batteries are combined in series and in parallel and stored in one combined battery casing.

Storage battery state detection units (first detection units) 38, 40, and 42 are provided in the combined battery casing for each of the storage battery packs 92, 94, and 96, respectively, and are sensors having a function to detect, as an internal state of the storage battery pack, a voltage between positive and negative electrodes of the storage battery pack, a current flowing in the storage battery pack, a temperature in the storage battery pack, etc., and to transmit the internal state to the control block 80. The storage battery state detection unit also has a function to detect an abnormality state such as excessive current, excessive discharging, excessive charging, etc. as the internal state of the storage battery pack and transmit the internal state to the control block 80. The storage battery state detection units 38, 40, and 42 and the control block 80 are connected by signal lines through which the internal state of the storage battery pack can be transmitted as a digital signal.

In each of the storage batteries 32, 34, and 36, two storage battery packs are connected in series, and, because the storage battery state detection unit is provided for each storage battery pack, a total of 6 storage battery state detection units are provided in the electricity storage device 30. The signal lines from two storage battery state detection units provided in the storage battery pack are connected to the control block 80.

As described, each of the storage batteries 32, 34, and 36 has, in the combined battery casing, various sensors and a transmission and reception circuit for the detected signal of the sensors. In the following description, in order to simplify the description, the two storage battery state detection units provided in each of the storage batteries 32, 34, and 36 will be collectively called storage battery state detection units 38, 40, and 42.

The control block 80 is a controlling device having a function to wholly control the constituent elements with regard to the charging and discharging of the electricity storage system 10. A display unit 82 connected to the control block 80 is a small-size display which can display an error content or the like during execution of a self-diagnosis function or the like. An operation lamp 84 is a display lamp which is switched ON during an operation state of the electricity storage system 10. An error lamp 86 is an alert display lamp which is switched ON when an abnormality occurs in the electricity storage system 10. Therefore, when the electricity storage system 10 is normally operating, the operation lamp 84 is switched ON and the error lamp 86 is switched OFF.

As described above, the control block 80 has a function to control the overall operation of the electricity storage system 10. The control block 80 comprises a charge and discharge control unit 160 which controls charging and discharging of the electricity storage device 30 by ON/OFF control of the charge switch 70 and the discharge switch 74, a storage battery selection control unit 200 which selects a storage battery to be charged or discharged among the storage batteries 32, 34, and 36 based on data of the detection units 62, 64, and 66, and a suitable charge and discharge monitoring unit 202 which monitors the storage batteries 32, 34, and 36 to prevent excessive charge or excessive discharge, based on the data of the storage battery state detection units 38, 40, and 42.

These functions of the control block 80 can be realized by executing software. More specifically, the functions can be realized by executing an electricity storage system charge and discharge program. Alternatively, a part of these functions may be realized using hardware.

The operation of the above-described structure; in particular, the functions of the control block 80, will now be described in detail. As described above, in the electricity storage system 10, the storage battery state detection units 38, 40, and 42 are provided in the electricity storage device 30, and the detection units 62, 64, and 66 are provided in the charge and discharge switch device 60. That is, storage battery state information such as, for example, the voltage, at the connection point between the electricity storage device 30 and the electricity storage device breaker 50 is detected by the storage battery state detection units 38, 40, and 42, and the state information such as, for example, the voltage, at the connection point between the electricity storage device breaker 50 and the charge and discharge switch device 60 is detected by the detection units 62, 64, and 66. With this configuration, because the state information related to the electricity storage device 30 is detected at two locations, the two different pieces of information will be distinguished in this description by calling the former voltage detected by the storage battery state detection units 38, 40, and 42 a first voltage and the latter voltage detected by the detection units 62, 64, and 66 a second voltage.

The suitable charge and discharge monitoring unit 202 has a function to receive information including the first voltage detected by the storage battery state detection units 38, 40, and 42 as input data, estimate the state of charge or the like of the storage batteries 32, 34, and 36, and monitor whether or not the state of charge is within a suitable range. The storage battery state detection units 38, 40, and 42 transmit the first voltage, a current, and a temperature of each of the storage batteries 32, 34, and 36 as detection information, and the suitable charge and discharge monitoring unit 202 estimates and calculates SOC (State Of Charge) representing the state of charge/discharge of each of the storage batteries 32, 34, and 36 based on the detection information. More specifically, a charge current and a discharge current are cumulatively calculated for each of the storage batteries 32, 34, and 36, to calculate an amount of charge with respect to the capacity of the storage battery, and the SOC can be estimated in consideration of the temperature dependency of the storage batteries 32, 34, and 36. In addition, the suitable charge and discharge monitoring unit 202 may be combined with a method in which a relationship between the SOC and the voltage is determined in advance, and the SOC is calculated using the first voltage detected by the storage battery state detection units 38, 40, and 42 in the case of a particular state. For example, the SOC may be calculated using the voltage only when the state is one of the completely discharged state, the fully charged state, the excessive discharged state, and the excessive charged state, and by the above-described method of cumulative calculation of the current in all other cases.

The detected first voltage is compared with a voltage (threshold) in a particular state as described above, and the suitable charge and discharge monitoring unit 202 monitors such that each of the storage batteries 32, 34, and 36 is not excessively charged or excessively discharged. For example, in a system having a fully charged voltage of 105 V, a completely discharged voltage of 80 V, an excessively charged voltage of 110 V, and an excessively discharged voltage of 65 V, the suitable charge and discharge monitoring unit 202 judges that a first voltage of greater than or equal to 105 V and less than 110 V or of greater than 65 V and less than or equal to 80 V indicates a non-preferable state, although there is no possibility of excessive charge or excessive discharge, and forcefully switches the charge switch 70 or the discharge switch 74 OFF. When the first voltage is greater than or equal to 110 V or less than or equal to 65 V, the suitable charge and discharge monitoring unit 202 judges that the device is in an abnormal state of possible excessive charge or excessive discharge, and outputs a disconnection instruction to the breakers 52, 54, and 56 corresponding to the storage battery, to disconnect the breaker. When the first voltage is greater than 80 V and less than 105 V, the suitable charge and discharge monitoring unit 202 judges that the storage batteries are in a suitable state which are neither excessively charged nor excessively discharged, and executes the charge and discharge control by ON/OFF control of the charge switch 70 and the discharge switch 74.

When it is judged, as a result of monitoring by the suitable charge and discharge monitoring unit 202, that the storage batteries are in the suitable state, and the ON/OFF control of the charge switch 70 and the discharge switch 74 is executed, this information is transmitted to the charge and discharge control unit 160, and the charge and discharge control unit 160 can execute the ON/OFF control of the charge switch 70 and the discharge switch 74 according to a requested amount of charge and discharge. When the storage batteries are in the abnormal state in which the electricity storage device breaker 50 is to be disconnected, the disconnection instruction is transmitted to the electricity storage device breaker 50. Although FIG. 1 shows that the disconnection instruction can be issued from the suitable charge and discharge monitoring unit 202 to the electricity storage device breaker 50, alternatively, the function to issue the disconnection instruction may be assigned as a function of the charge and discharge control unit 160. As described, the suitable charge and discharge monitoring unit 202 can monitor the device based on the first voltage, which is the voltage of the electricity storage device 30 itself, to prevent the electricity storage device 30 from being excessively charged or excessively discharged.

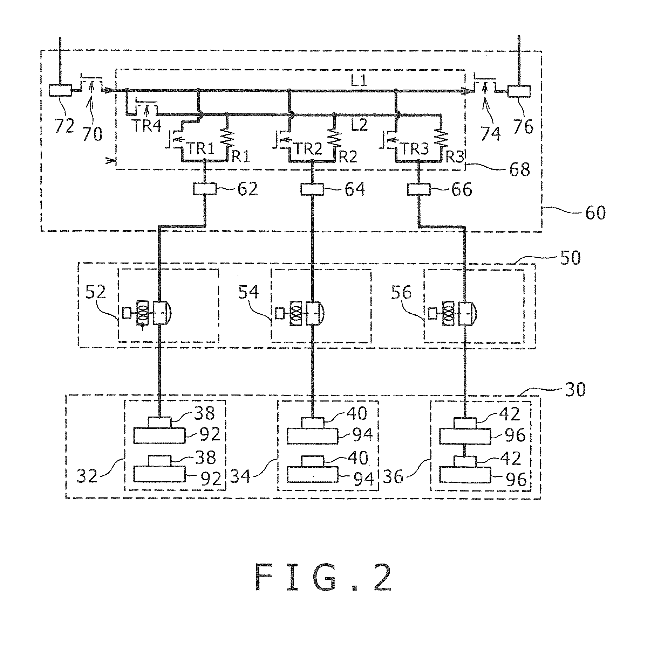

Next, a function of a storage battery selection control unit 200 will be described with reference to FIG. 2. FIG. 2 is a diagram picking and showing, among the constituent elements of the electricity storage system 10, the electricity storage device 30, the electricity storage device breaker 50, and the charge and discharge switch device 60.

A storage battery selection refers to a process of identifying and selecting a storage battery to be used for charging and discharging, according to a predefined selection standard, when there is a difference in the states of charge of the storage batteries 32, 34, and 36. The state of charge of each of the storage batteries 32, 34, and 36 may be substituted by the first voltage. From the viewpoint of the charge and discharge switch device 60 which actually switches the charge switch 70 and the discharge switch 74 ON and OFF, the first voltage is separated by the electricity storage device breaker 50. Each of the breakers 52, 54, and 56 of the electricity storage device breaker 50 has an internal resistance, and the internal resistances may not be the same. In addition, depending on the placement location of the electricity storage device 30, the line connecting the electricity storage device 30 and the charge and discharge switch device 60 may be elongated, resulting in an increase in the internal resistance of the line. Therefore, as the storage battery voltage substituting for the state of charge used for the storage battery selection, the second voltage, in which error due to the electricity storage device breaker 50 and the internal resistance does not occur, is used.

In FIG. 2, in the storage battery selection circuit 68 included in the charge and discharge switch device 60, resistor elements R1, R2, and R3 are respectively connected in series between the charge switch 70 and each of the detection units 62, 64, and 66. The resistor elements R1, R2, and R3 have a function to gradually reduce, when there is a difference in the states of charge of the storage batteries 32, 34, and 36 and there is a difference in the second voltage corresponding to each of the storage batteries 32, 34, and 36, the difference by gradually flowing a current over a period of time.

In addition, in the storage battery selection circuit 68, switching elements TR1, TR2, and TR3 are respectively connected in series between the discharge switch 74 and each of the detection units 62, 64, and 66. The switching elements TR1, TR2, and TR3 may be formed with FETs. The switching elements TR1, TR2, and TR3 are selection switches having a function to connect a corresponding storage battery to a charge and discharge line shown by L1 by being switched ON and to disconnect the corresponding storage battery from the charge and discharge line L1 by being switched OFF.

TR4 represents a switching element which connects the charge and discharge line L1 and a sub-line L2, to enable charging and discharging of the storage batteries 32, 34, and 38 through the resistor elements R1, R2, and R3.

Because the lithium ion battery has a low internal resistance, when the lithium ion batteries are connected in parallel to the charge and discharge line L1 as shown in FIG. 2, a large current flows from a storage battery having a higher second voltage to a storage battery having a lower second voltage. When the difference in the second voltage corresponding to each storage battery is too high, the amount of current to flow becomes too large, resulting in a possible damage to the storage battery.

In consideration of this, only the storage battery in which the second voltage is within a predetermined range which is defined in advance is connected to the charge and discharge line L1, and the storage battery in which the second voltage is not within the predetermined range is not connected to the charge and discharge line L1. In this manner, the storage battery to be used for charging and discharging is identified and selected based on the value of the second voltage. This is the content of the storage battery selection control.

As described, in the storage battery selection control, the selection of the storage battery to be used for charging and discharging must be executed with a voltage difference of less than 1 V, and accurate selection is difficult with the first voltage through the electricity storage device breaker 50. Therefore, the storage battery selection is executed using the second voltage. With regard to the suitable charge and discharge monitoring of the storage batteries 32, 34, and 36 using the second voltage, accurate monitoring is difficult because the voltage is a voltage value through the electricity storage device breaker 50. In addition, when, for example, an abnormality occurs in the storage battery 34 for some reason and only the breaker 54 among the breakers 52, 54, and 56 is disconnected, the second voltage at the upstream of the breaker 54 would have a value close to the second voltages at the upstream of the breakers 52 and 56.

In other words, after the breaker 54 is disconnected, at least the voltage output of the detection unit 64 must be ignored as data for measuring the SOC of the storage battery 34. Thus, when the suitable charge and discharge monitoring of the storage batteries 32, 34, and 36 is executed using the second voltage, when only one of the breakers is disconnected, the SOC of the storage battery corresponding to that breaker cannot be suitably recognized.

On the other hand, with regard to the values of the storage battery state detection units 38, 40, and 42, correct values are output as the voltages of the storage batteries even if any of the breakers 52, 54, and 56 is disconnected. Therefore, by executing the suitable charge and discharge monitoring using the first voltage, it is possible to determine the suitable SOC, voltage, etc., of a new storage battery at the time when a malfunctioned storage battery is replaced with the new storage battery, and to prevent flow of a large current due to connection of a storage battery having a different voltage when the breaker is re-connected.

Because of the above-described reasons, the first voltage and the second voltage are distinctly used for the suitable charge and discharge monitoring and the storage battery selection control, respectively. With such a configuration, charge and discharge control can be executed while inhibiting the influence of the electricity storage device breaker 50 provided between the electricity storage device 30 and the charge and discharge switch device 60, and a suitable SOC of the storage battery can be recognized even when only one of the breakers is disconnected.

Normally, the storage battery selection is executed based on the value of the second voltage, but when one of the breakers 52, 54, and 56 is disconnected, the second voltage cannot be measured. In this case, the value of the first voltage may be substituted for executing the storage battery selection control. In addition, in the measurement of the second battery, when the storage battery packs 92, 94, and 96 in the storage batteries 32, 34, and 36 are in multiple series connection, the voltages of the storage battery packs 92, 94, and 96 do not need to be summed, and the measured valuescan be used withoutfurther processing. Therefore, the second voltage is preferable for use in the abnormality judgment of the electricity storage device.

The control block 80 compares the storage battery state information detected by the storage battery state detection units 38, 40, and 42 corresponding to the storage batteries 32, 34, and 36, respectively, and the state information detected by the detection units 62, 64, and 66, and, when the difference between these information exceeds predefined value, the control block 80 judges that there is an abnormality such as contact deficiency, electricity leakage, detection unit error, etc. between the storage battery state detection units 38, 40, and 42 and the detection units 62, 64, and 66, and transmits a disconnection instruction to the electricity storage device breaker 50. The predefined value may be a fixed value or a value which changes according to the current value.

For example, a current difference between the storage battery state detection units 38, 40, and 42 and the detection units 62, 64, and 66 is measured, and, when the difference exceeds 1 A, it is judged that there is a possibility of leaking current, and the disconnection instruction is transmitted to the storage battery breaker 50. In addition, a voltage difference between the storage battery state detection units 38, 40, and 42 and the detection units 62, 64, and 66 is measured, and, when the difference exceeds 3 V, it is judged that there is a resistive portion due to contact deficiency or the like which is greater than expected, and the disconnection instruction is transmitted to the storage battery breaker 50. Alternatively, the voltage difference may be a voltage calculated by current value X (expected resistance increase due to occurrence of contact deficiency), in place of the fixed value. The expected resistance increase due to occurrence of contact deficiency is, for example, 1 Ω. In this case, in addition to the contact deficiency described above, an error of the detection unit itself may be considered, and, thus, when the voltage difference is greater than or equal to 3 V, the charge and discharge switch device 60 is temporarily switched OFF, and, if the state with the voltage difference continues in the state where the current is disconnected, it is judged as the error in the detection unit, and, if the voltage difference is resolved, it is judged as occurrence of the contact deficiency.

### [Industrial Applicability]

The electricity storage system according to the present invention can be used in a system having a plurality of storage batteries and a breaker.

### [Explanation of Reference Numerals]

10 ELECTRICITY STORAGE SYSTEM; 12 EXTERNAL COMMERCIAL POWER SUPPLY; 14 PHOTOELECTRIC CONVERSION ARRAY; 16AC LOAD; 18 DC LOAD; 20 SWITCHING DEVICE; 22 DC-AC INVERTER; 24 AC-DC CONVERTER; 26 LOAD-SIDE BREAKER; 28 DC-DC CONVERTER; 30 ELECTRICITY STORAGE DEVICE; 32, 34, 36 STORAGE BATTERY; 38, 40, 42 STORAGE BATTERY STATE DETECTION UNIT; 50 ELECTRICITY STORAGE DEVICE BREAKER; 52, 54, 56 BREAKER; 60 CHARGE AND DISCHARGE SWITCH DEVICE; 62, 64, 66 DETECTION UNIT; 68 STORAGE BATTERY SELECTION CIRCUIT; 70 CHARGE SWITCH; 72 CHARGE-SIDE CURRENT AND VOLTAGE DETECTION UNIT; 74 DISCHARGE SWITCH; 76 DISCHARGE-SIDE CURRENT AND VOLTAGE DETECTION UNIT; 80 CONTROL BLOCK; 82 DISPLAY UNIT; 84 OPERATION LAMP; 86 ERROR LAMP; 92, 94, 96 STORAGE BATTERY PACK; 160 CHARGE AND DISCHARGE CONTROL UNIT; 200 STORAGE BATTERY SELECTION CONTROL UNIT; 202 SUITABLE CHARGE AND DISCHARGE MONITORING UNIT

## Claims

1. An electricity storage system comprising:
an electricity storage device which has a storage battery, charges electric power supplied from an electric power supply, and discharges the charged electric power to an external load;
a charge and discharge control unit which controls charging and discharging;
a suitable charge and discharge monitoring unit which monitors a state of charge and discharge;
a breaker which is connected to the electricity storage device;
a first detection unit which detects storage battery state information from a side nearer to the storage battery than the breaker; and
a second detection unit which detects state information from a side nearer to the electric power supply than the breaker.

2. The electricity storage system according to Claim 1, further comprising:
a charge and discharge switch device which is connected to the electricity storage device, wherein
the breaker is provided between the electricity storage device and the charge and discharge switch device.

3. The electricity storage system according to Claim 1 or 2, wherein
the charge and discharge control unit compares the storage battery state information detected by the first detection unit and the state information detected by the second detection unit, and outputs a disconnection instruction to the breaker according to a difference in these information, to disconnect the storage battery from at least one of the electric power supply or the external load.
